# EUROPEAN PATENT APPLICATION

(11) **EP 1 614 768 A1**
(43) Date of publication of application: **11.01.2006**
(21) Application number: 04710475.7
(22) Date of filing: 12.02.2004
(51) Int. Cl.: C23C 16/34, C23C 16/455, H01L 21/285

(54) **METHOD FOR FORMING FILM**

(30) Priority: 20.02.2003 JP 2003042897
(71) Applicant: TOKYO ELECTRON LIMITED, Minato-ku, Tokyo 107-8481 (JP)
(72) Inventor: HASEGAWA, Toshio, Tokyo Electron AT Limited, Nirasaki-shi, Yamanashi 407-0192 (JP)
(74) Representative: Liesegang, Eva
(86) International application number: PCT/JP2004/001476
(87) International publication number: WO 2004/074543

(57) **Abstract**

The present invention relates to a method of forming a metal-nitride film onto a surface of an object to be processed in a processing container in which a vacuum can be created. The method of the invention includes: a step of continuously supplying an inert gas into a processing container set at a high film-forming temperature; and a step of intermittently supplying a metal-source gas into the processing container, during the step of continuously supplying the inert gas. During the step of intermittently supplying the metal-source gas, a nitrogen-including reduction gas is supplied into the processing container at the same time that the metal-source gas is supplied, during a supply term of the metal-source gas. The nitrogen-including reduction gas is also supplied into the processing container for a term shorter than a non-supply term of the metal-source gas, during the non-supply term of the metal-source gas. A film thickness of the metal-nitride film formed during the one supply term of the metal-source gas is not more than 60 nm. According to the invention, although the film-forming process is conducted at a relatively high temperature, a metal-nitride film can be deposited whose chlorine density is low, whose resistivity is low, and in which fewer cracks may be generated.

## Description

### Field of the Invention

The present invention relates to a film-forming method for depositing a metal-nitride film such as a TiN (Titanium nitride) film onto a surface of an object to be processed such as a semiconductor wafer.

### Description of the related art

In general, a circuitry is often composed by a multilevel interconnection structure in a semiconductor device in response to a request for recent enhanced density and enhanced integration. In this case, a technique for filling a contact hole, which is a connection part between a lower-layer device and an upper-layer aluminum wiring, and a via hole, which is a connection part between a lower-layer aluminum wiring and an upper-layer aluminum wiring, is important to provide an electrical connection therebetween.

Sputter aluminum and CVD tungsten are generally used as the technique to fill the contact hole, the via hole and the like. Recently, there is a tendency that the CVD tungsten is mainly used because of a higher filling performance thereof.

However, when a tungsten film is formed directly onto a silicon layer or an aluminum wiring which is a lower layer, a diffusion layer formed in the silicon layer is destroyed by an attack of fluorine and/or an adhesiveness to an upper layer becomes worse, at a boundary portion therebetween. This is not preferable for the current semiconductor device, to which an electric-power saving and a high-speed operation are required.

Moreover, when tungsten is used for the filling, WF₆ gas which is one of process gases used in this process breaks into the Si substrate side so as to deteriorate electric properties and the like. This tendency is not preferable.

Consequently, in order to prevent the above phenomenon, before filling a contact hole, a through hole and the like with the tungsten, a barrier metal layer is thinly formed all over the surface of a wafer including a surface inside the hole. A double-layer structure of Ti/TiN (titanium nitride) or a single-layer structure of TiN is generally used as a material of this barrier metal layer. Regarding prior arts, there are Japanese Patent Laid-Open Publication (Kokai) No. Hei-6-89873, Japanese Patent Laid-Open Publication (Kokai) No. Hei-10-106974, "Decomposition Property of Methylhydrazine with Titanium Nitridation at Low Temperature" (P. 934-938, J. Electrochem. Soc., Vol. 142 no.3, March 1995), and so on.

For example, a case of forming only a TiN film is explained. As a film-forming gas, for example, a TiCl₄ gas and a NH₃ gas are used. These gases are introduced continuously and synchronously for a predetermined time into a processing container in which a vacuum has been created. Then, a TiN film is deposited on a surface of a wafer by means of a thermal CVD (Chemical Vapor Deposition) at a predetermined process temperature. After the TiN film is formed, into the same processing container, only the NH₃ gas is introduced for a predetermined time without introducing the TiCl₄ gas (which is called "post flow of NH₃ gas"). Thus, Cl elements remaining in the TiN film are removed. The reason of conducting the post-flow step is that if any Cl element remains in the film, resistivity of the film may increase and/or corrosion thereof may occur.

Herein, when the above TiN film is formed, in order to improve throughput, the TiN film is formed at a relatively high process temperature, for example about 560 °C. When the process temperature is relatively high like this, less micro cracks or the like may be generated in the deposited film. However, the inventor has found that micro cracks may be generated when a film thickness of the deposited TiN film is thickened over a certain degree.

In addition, when a base layer, onto which the TiN film is formed, is a Ti layer, the TiN film deposited on that may peel off relatively easily.

### SUMMARY OF THE INVENTION

This invention is developed by focusing the aforementioned problems in order to resolve them effectively. An object of the present invention is to provide a film-forming method of a metal-nitride film in which less micro cracks and less peeling off may occur even at a relatively high temperature.

The present invention is a film-forming method of forming a metal-nitride film onto a surface of an object to be processed in a processing container in which a vacuum can be created, the film-forming method comprising: a step of continuously supplying an inert gas into a processing container set at a high film-forming temperature; a step of intermittently supplying a metal-source gas into the processing container, during the step of continuously supplying the inert gas; a step of supplying a nitrogen-including reduction gas into the processing container at the same time that the metal-source gas is supplied, during a supply term of the metal-source gas, during the step of intermittently supplying the metal-source gas; and a step of supplying the nitrogen-including reduction gas into the processing container for a term shorter than a non-supply term of the metal-source gas, during the non-supply term of the metal-source gas, during the step of intermittently supplying the metal-source gas; wherein a film thickness of the metal-nitride film formed during the one supply term of the metal-source gas is not more than 60 nm.

According to the above feature, although the film-forming process is conducted at a relatively high temperature, a metal-nitride film can be deposited whose chlorine density is low, whose resistivity is low, and in which fewer cracks may be generated.

Specifically, the high film-forming temperature is 500 °C to 700 °C.

Preferably, during the step of supplying the nitrogen-including reduction gas into the processing container for a term shorter than a non-supply term of the metal-source gas, during the non-supply term of the metal-source gas, a second nitrogen-including reduction gas, whose reducing power is greater than that of the nitrogen-including reduction gas, is adapted to be supplied at the same time that the nitrogen-including reduction gas is supplied.

Alternatively, during the step of supplying the nitrogen-including reduction gas into the processing container for a term shorter than a non-supply term of the metal-source gas, during the non-supply term of the metal-source gas, a plasma-assist gas is adapted to be supplied at the same time that the nitrogen-including reduction gas is supplied, so as to generate plasma. In the case, more preferably, a reduction gas is adapted to be supplied at the same time that the plasma-assist gas is supplied.

In addition, the present invention is a film-forming method of forming a metal-nitride film onto a surface of an object to be processed in a processing container in which a vacuum can be created, the film-forming method comprising: a step of continuously supplying an inert gas and a nitrogen-including reduction gas into a processing container set at a high film-forming temperature; and a step of intermittently supplying a metal-source gas into the processing container, during the step of continuously supplying the inert gas and the nitrogen-including reduction gas; wherein a film thickness of the metal-nitride film formed during the one supply term of the metal-source gas is not more than 60 nm.

According to the above feature as well, although the film-forming process is conducted at a relatively high temperature, a metal-nitride film can be deposited whose chlorine density is low, whose resistivity is low, and in which fewer cracks may be generated.

In the case as well, specifically, the high film-forming temperature is 500 °C to 700 °C.

Preferably, a second nitrogen-including reduction gas, whose reducing power is greater than that of the nitrogen-including reduction gas, is adapted to be supplied into the processing container for a term shorter than a non-supply term of the metal-source gas, during the non-supply term of the metal-source gas, during the step of intermittently supplying the metal-source gas.

Alternatively, a plasma-assist gas is adapted to be supplied into the processing container for a term shorter than a non-supply term of the metal-source gas, during the non-supply term of the metal-source gas, during the step of intermittently supplying the metal-source gas, so as to generate plasma. In the case, more preferably, a reduction gas is adapted to be supplied at the same time that the plasma-assist gas is supplied.

In addition, the present invention is a film-forming method of forming a metal-nitride film onto a surface of an object to be processed in a processing container in which a vacuum can be created, the film-forming method comprising: a step of continuously supplying an inert gas into a processing container set at a high film-forming temperature; a step of intermittently supplying a metal-source gas into the processing container, during the step of continuously supplying the inert gas; a step of supplying a nitrogen-including reduction gas into the processing container for a term shorter than a supply term of the metal-source gas, during the supply term of the metal-source gas, during the step of intermittently supplying the metal-source gas; and a step of supplying the nitrogen-including reduction gas into the processing container for a term shorter than a non-supply term of the metal-source gas, during the non-supply term of the metal-source gas, during the step of intermittently supplying the metal-source gas; wherein a film thickness of the metal-nitride film formed during the one supply term of the metal-source gas is not more than 60 nm.

According to the above feature as well, although the film-forming process is conducted at a relatively high temperature, a metal-nitride film can be deposited whose chlorine density is low, whose resistivity is low, and in which fewer cracks may be generated.

In the case as well, specifically, the high film-forming temperature is 500 °C to 700 °C.

Preferably, during the step of supplying the nitrogen-including reduction gas into the processing container for a term shorter than a supply term of the metal-source gas, during the supply term of the metal-source gas, either the start or the stop of supplying the nitrogen-including reduction gas is set at the same time as either the start or the stop of supplying the metal-source gas.

In addition, preferably, during the step of supplying the nitrogen-including reduction gas into the processing container for a term shorter than a non-supply term of the metal-source gas, during the non-supply term of the metal-source gas, a second nitrogen-including reduction gas, whose reducing power is greater than that of the nitrogen-including reduction gas, is adapted to be supplied at the same time that the nitrogen-including reduction gas is supplied.

Alternatively, preferably, during the step of supplying a nitrogen-including reduction gas into the processing container for a term shorter than a non-supply term of the metal-source gas, during the non-supply term of the metal-source gas, a plasma-assist gas is adapted to be supplied at the same time that the nitrogen-including reduction gas is supplied, so as to generate plasma. In the case, more preferably, a reduction gas is adapted to be supplied at the same time that the plasma-assist gas is supplied.

In addition, the present invention is a film-forming method of forming a metal-nitride film onto a surface of an object to be processed in a processing container in which a vacuum can be created, the film-forming method comprising: a step of continuously supplying an inert gas into a processing container set at a high film-forming temperature; a step of intermittently supplying a metal-source gas into the processing container, during the step of continuously supplying the inert gas; a step of supplying a nitrogen-including reduction gas into the processing container at the same time that the metal-source gas is supplied, during a supply term of the metal-source gas, during the step of intermittently supplying the metal-source gas; and a step of supplying a second nitrogen-including reduction gas, whose reducing power is greater than that of the nitrogen-including reduction gas, into the processing container for a term shorter than a non-supply term of the metal-source gas, during the non-supply term of the metal-source gas, during the step of intermittently supplying the metal-source gas; wherein a film thickness of the metal-nitride film formed during the one supply term of the metal-source gas is not more than 60 nm.

According to the above feature as well, although the film-forming process is conducted at a relatively high temperature, a metal-nitride film can be deposited whose chlorine density is low, whose resistivity is low, and in which fewer cracks may be generated.

In the case as well, specifically, the high film-forming temperature is 500 °C to 700 °C.

In addition, the present invention is a film-forming method of forming a metal-nitride film onto a surface of an object to be processed in a processing container in which a vacuum can be created, the film-forming method comprising: a step of continuously supplying an inert gas into a processing container set at a high film-forming temperature; a step of intermittently supplying a metal-source gas into the processing container, during the step of continuously supplying the inert gas; a step of supplying a nitrogen-including reduction gas into the processing container at the same time that the metal-source gas is supplied, during a supply term of the metal-source gas, during the step of intermittently supplying the metal-source gas; and a step of supplying a plasma-assist gas into the processing container for a term shorter than a non-supply term of the metal-source gas and continuous to the next supply term of the metal-source gas, during the non-supply term of the metal-source gas, during the step of intermittently supplying the metal-source gas, so as to generate plasma; wherein a film thickness of the metal-nitride film formed during the one supply term of the metal-source gas is not more than 60 nm.

According to the above feature as well, although the film-forming process is conducted at a relatively high temperature, a metal-nitride film can be deposited whose chlorine density is low, whose resistivity is low, and in which fewer cracks may be generated.

In the case as well, specifically, the high film-forming temperature is 500 °C to 700 °C.

Preferably, a reduction gas is adapted to be supplied at the same time that the plasma-assist gas is supplied.

In addition, the metal-source gas is for example TiCl₄ gas, and the nitrogen-including reduction gas is for example NH₃ gas.

In the case, it is preferable that a Ti layer has been formed as a base layer on the surface of the object to be processed, onto which the metal-nitride film is to be formed, and that a film thickness of the metal-nitride film formed during the one supply term of the metal-source gas is not more than 20 nm.

In addition, the inert gas is for example N₂ gas. Alternatively, the inert gas is for example Ar gas.

The second nitrogen-including reduction gas is for example any of hydrazine, monomethylhydrazine and dimethylhydrazine.

### BRIEF DESCRIPTION OF THE DRAWINGS

Fig. 1 is a schematic cross sectional view showing an example of processing unit for carrying out a film-forming method according to the present invention;
Fig. 2 is a chart showing timings of supply of various gases in a first embodiment according to the present invention;
Fig. 3 is a graph showing a relationship between numbers of cycles of gas-supply and resistivities of TiN films;
Fig. 4 is a graph showing a relationship between wafer temperatures and chlorine densities in TiN films;
Fig. 5 is a graph showing a relationship between film thicknesses and resistivities;
Fig. 6 is a graph showing temperature dependency of stresses with respect to film thicknesses;
Fig. 7 is a chart showing timings of supply of various gases in a first variant of the first embodiment;
Fig. 8 is a chart showing timings of supply of various gases and timings of generation of plasma, in a second variant of the first embodiment;
Fig. 9 is a chart showing timings of supply of various gases in a second embodiment according to the present invention;
Fig. 10 is a chart showing timings of supply of various gases in a first variant of the second embodiment;
Fig. 11 is a chart showing timings of supply of various gases and timings of generation of plasma, in a second variant of the second embodiment;
Fig. 12 is a chart showing timings of supply of various gases in a third embodiment according to the present invention;
Fig. 13 is a chart showing timings of supply of various gases in a third embodiment (i);
Fig. 14 is a chart showing timings of supply of various gases in a third embodiment (ii);
Fig. 15 is a chart showing timings of supply of various gases in a first variant of the third embodiment;
Fig. 16 is a chart showing timings of supply of various gases and timings of generation of plasma, in a second variant of the third embodiment;
Fig. 17 is a chart showing timings of supply of various gases in a fourth embodiment according to the present invention;
Fig. 18 is a chart showing timings of supply of various gases and timings of generation of plasma, in a fifth embodiment according to the present invention; and
Fig. 19 is a table showing a relationship between film thicknesses of the whole TiN film and film thicknesses formed by one cycle.

### DESCRIPTION OF THE PREFERRED EMBODIMENT

Hereinafter, embodiments of a film-forming method according to the present invention will be described in detail based on the attached drawings.

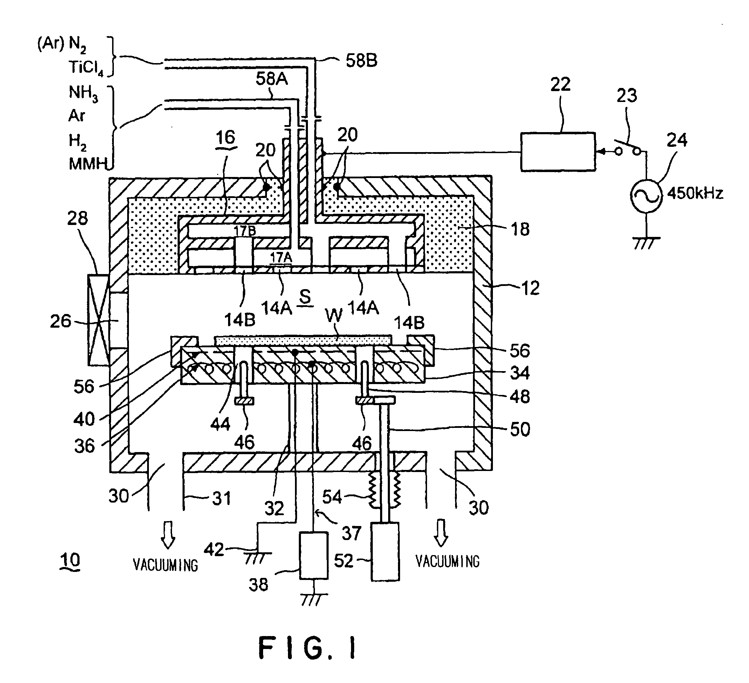

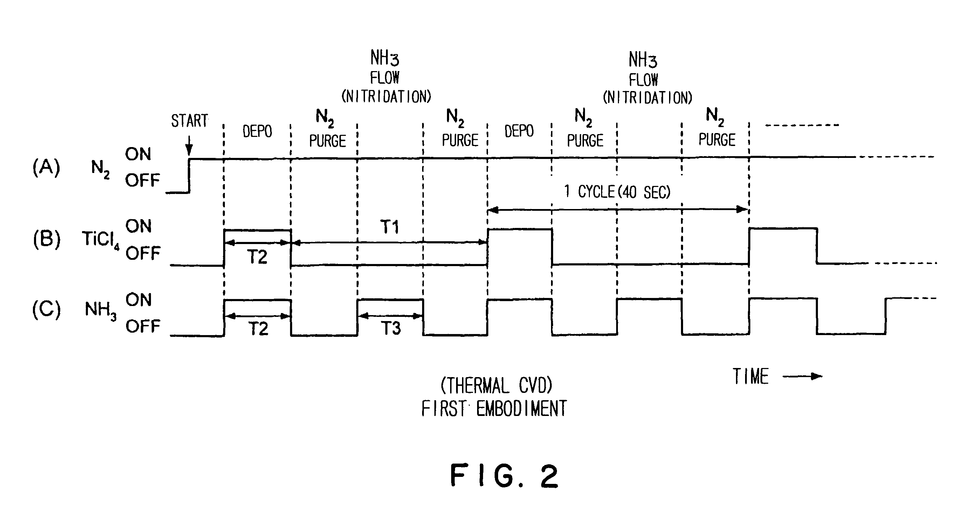

Fig. 1 is a schematic cross sectional view showing an example of processing unit for carrying out a film-forming method according to the present invention, and Fig. 2 is a chart showing timings of supply of various gases in a first embodiment according to the present invention. Herein, a case is explained as an example, wherein the processing unit is a plasma CVD film-forming unit and the metal-nitride film is a TiN film. The plasma CVD film-forming unit may be also used as a thermal CVD film-forming unit if a high-frequency voltage is not applied thereto so that no plasma is generated.

As shown in Fig. 1, the plasma CVD film-forming unit 10 as a processing unit has a processing container 12 formed cylindrically and made of, for example, nickel or a nickel alloy. A ceiling part of the processing container 12 is provided with a showerhead 16, which has a large number of gas-jetting holes (ways) 14A, 14B in a lower surface thereof. Thus, a process gas such as a film-forming gas or the like can be introduced into a processing space S in the processing container 12. For example two gas spaces 17A, 17B are separately defined in the showerhead 16. The gas jetting holes 14A, 14B are respectively communicated with the gas spaces 17A, 17B. Thus, the two gases are adapted to be first mixed in the processing space S. This manner of supplying the gases is called "post mix".

The whole showerhead 16 is made of an electric conductor such as nickel or a nickel alloy and thus serves as an upper electrode. An outside peripheral surface and an upper surface of the showerhead 16, which serves as the upper electrode, are entirely covered with an insulating member 18 such as quartz or alumina (Al₂O₃). The showerhead 16 is fixed to the processing container 12 with an insulation state via the insulating member 18. In the case, sealing members 20 such as O-rings or the like are respectively interposed at connecting parts between the showerhead 16, the insulating member 18 and the processing container 12. Thus, airtightness in the processing container 12 can be maintained.

Then, a high-frequency electric power source 24 that generates a high-frequency electric voltage of for example 450 kHz is connected to the showerhead 16 via a matching circuit 22 and a open-close switch 23. Thus, when necessary, the high-frequency electric voltage is applied to the showerhead 16, which is the upper electrode. The frequency of the high-frequency electric voltage is not limited to 450 kHz, but could be for example 13.56 MHz or the like.

In addition, a port 26, through which a wafer is conveyed, is formed at a lateral wall of the processing container 12. A gate valve 28 that can be opened and closed is provided at the port 26. A load-lock chamber or a transfer chamber or the like, not shown, can be connected to the gate valve 28.

An exhausting port 30 is provided at a bottom of the processing container 12. An exhausting pipe 31 is connected to the exhausting port 30, a vacuum pump or the like, not shown, being provided on the way of the exhausting pipe 31. Thus, when necessary, a vacuum can be created in the processing container 12. In the processing container 12, a stage 34, onto which a semiconductor wafer W as an object to be processed is placed, is provided via a column 32 from the bottom. The stage 34 serves as a lower electrode. Then, plasma can be generated by means of the high-frequency electric voltage in the processing space S between the stage 34 as the lower electrode and the showerhead 16 as the upper electrode.

Specifically, the whole stage 34 is made of a ceramics such as AIN. A heater 36, which consists of for example a resistive element such as a molybdenum wire, is buried in the stage 34 in a predetermined pattern. A heater electric power source 38 is connected to the heater 36 via a wiring 37. Thus, if necessary, electric power can be supplied to the heater 36. In addition, an electrode body 40, which is for example a mesh of molybdenum wire, is buried in the stage 34 above the heater 36, so as to spread out in the whole in-plane (radial) directions of the stage 34. The electrode body 40 is grounded via a wiring 42. Herein, a high-frequency electric voltage as a bias voltage can be applied to the electric body 40.

A plurality of pin-holes 44 that extend through vertically are formed in the stage 34. A pushing-up pin 48 made of for example quartz, whose lower end is commonly connected to a connecting ring 46, is inserted in each pin-hole 44 in a freely movable manner. The connecting ring 46 is connected to an upper end of a protrudable rod 50, which extends through the bottom of the processing container in a vertically movable manner. The lower end of the protrudable rod 50 is connected to an air cylinder 52. Thus, each pushing-up pin 48 can protrude upward from an upper end of each pin-hole 44 and subside downward, when the wafer W is conveyed thereto or therefrom. An extendable bellows 54 is provided for a penetration part of the bottom of the processing container by the protrudable rod 50. Thus, the protrudable rod 50 can be vertically moved while maintaining the airtightness in the processing container 12.

A focus ring 56 is provided at a peripheral portion of the stage 34 as the lower electrode so as to concentrate the plasma into the processing container S. The gas pipes 58A, 58B are connected to the ceiling part of the showerhead 16 so as to communicate with the gas spaces 17A, 17B, respectively.

An N₂ gas or an Ar gas as an inert gas and/or a TiCl₄ gas as a metal source gas is adapted to be supplied through the gas pipe 58B together with a carrier gas (for example, N₂ gas). On the other hand, an NH₃ gas as a nitrogen-including reduction gas, an Ar gas as a plasma assist gas, an H₂ gas as a reduction gas and/or an MMH (monomethylhydrazine) gas as a second nitrogen-including reduction gas whose reducing power is greater than that of the NH₃ gas are adapted to be supplied through the gas pipe 58A.

Herein, in the above description, all the gases used in below explained embodiments are referred to. However, all the gases are not used for one film-forming process, but only necessary gases are supplied depending on the respective embodiments. Thus, it is natural that each gas can be supplied and stopped supplying independently and selectively if necessary. In addition, control of flow rate for each gas can be also carried out independently.

Herein, the high-frequency electric power source 24 for generating the plasma is provided, but a film-forming process can be also carried out by means of a mere thermal CVD without using plasma. Such a film-forming process by means of a thermal CVD can be carried out by a film-forming unit with for example a heating lamp.

Then, with reference to Fig. 2, the first embodiment of the film-forming method is explained.

Herein, without using plasma, a TiN film is deposited by means of a thermal CVD. In the first embodiment, an N₂ gas (see Fig. 2(A)) is used as an inert gas, a TiCl₄ gas (see Fig. 2(B)) is used as a metal source gas, and an NH₃ gas (see Fig. 2(C)) is used as a nitrogen-including reduction gas. The above gases are supplied in accordance with pulse-patterns in time, as shown in Fig. 2. That is, the N₂ gas as the inert gas is continuously supplied, while the TiCl₄ gas as the metal source gas is intermittently supplied, and the NH₃ gas as the nitrogen-including reduction gas is supplied at the same time that the metal source gas is supplied and also during non-supply terms of the source gas for shorter terms than the non-supply terms.

Here, "ON" in Fig. 2 designates a gas supply state, while "OFF" designates a gas non-supply state. This is the same for other drawings showing timings of supply of the gases.

As shown in Fig. 2, in a state wherein a vacuum is created in the processing container 12, the N₂ gas is continuously supplied, the TiCl₄ gas is intermittently supplied, and the NH₃ gas is supplied at the same time that the TiCl₄ gas is supplied and also during non-supply terms T1 of the TiCl₄ gas for terms shorter than the non-supply terms T1. Thus, a step cycle of DEPO (deposition of TiN film) → N₂ PURGE → NH₃ FLOW (nitridation of TiN film (reduction of chlorine)) → N₂ PURGE (→ DEPO → N₂ PURGE → NH₃ FLOW →) ... is repeated the number of times in accordance with the necessity. At the DEPO step, the TiN film is deposited. At the NH₃ FLOW step, chlorine remaining in the TiN film is moved away so that the portion is nitrided (reduction of the chlorine is carried out).

Herein, a term from a timing at which the TiCl₄ gas starts to be supplied to the next timing at which the TiCl₄ gas starts to be supplied is defined as one cycle. In the present embodiment, the term of the cycle is about 40 seconds. Of course, the term of the cycle is not limited thereto, but could be for example in a range of 10 to 60 seconds.

In addition, a supply term T2 for which the TiCl₄ gas and the NH₃ gas are synchronously supplied is about 10 seconds, and a term T3 for which the NH₃ gas is solely supplied is about 10 seconds. The term T3 is set at a substantially center of the non-supply term T1 of the TiCl₄ gas.

A process temperature (film-forming temperature) is a relatively high temperature, for example within a range of 500 to 700 °C (as a wafer temperature), specifically for example 600 °C.

With respect to gas flow rates, about 500 sccm is for the N₂ gas, about 30 sccm is for the TiCl₄ gas, and about 30 sccm is for the NH₃ gas.

In the case, a film thickness of the TiN film formed during one cycle (including one supply term of the metal-source gas) is set not more than 60 nm, although it depends on the process temperature. This point is described later.

Thus, it is possible to lower chlorine density that may be contained in the TiN film, at a relatively high process temperature, by intermittently depositing a plurality of very thin films in sequence by intermittently supplying the film-forming gas. In addition, the TiN film can have a low resistivity, and fewer cracks may occur in the TiN film. On the other hand, since the process temperature is relatively high, high throughput may be maintained. In addition, when a through hole or a contact hole is filled, as described above, it may be filled suitably and efficiently without generating cracks.

In particular, in the first embodiment, as shown in Fig. 2, there are N₂ PURGE steps before and after the DEPO step. Thus, the TiCl₄ gas and the NH₃ gas, which are gases contributing to the film-forming, are completely removed. Thus, step coverage at step portions may be improved, and overhang of the TiN film at through holes, contact holes or via holes may be prevented.

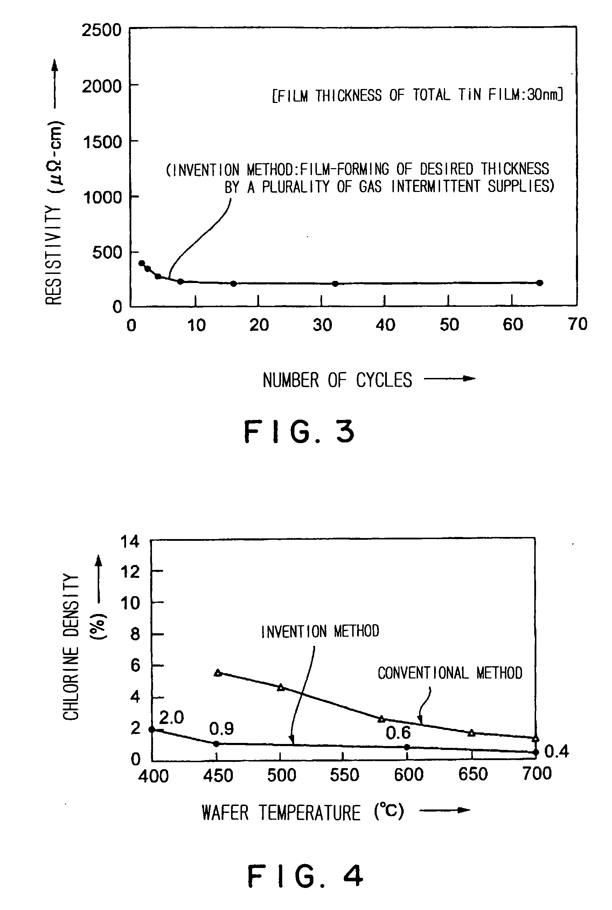

Next, a result of the first embodiment is explained compared with a result of a conventional film-forming method (wherein a desired film thickness is deposited by one gas-supply at a process temperature of 580 °C). Fig. 3 is a graph showing a relationship between numbers of cycles of gas-supply and resistivities of TiN films. Fig. 4 is a graph showing a relationship between wafer temperatures and chlorine densities in TiN films.

At first, Fig. 3 shows dependence of resistivity of the TiN film on the number of cycles of gas-supply, when average total thickness of the formed TiN film is about 30 nm. Herein, for example, if a film having a thickness of 30 nm is deposited by the number of cycles of "sixteen", the respective gas flow rates are controlled so that a film having a thickness of about 1.9 nm is deposited per one cycle.

As seen clearly from Fig. 3, in the present case wherein the process temperature is set at 600 °C, both when a thickness of 30 nm is formed by several cycles and when a thickness of 30 nm is formed by sixty-four cycles or so, resistivities of the films are not so different, and they are both low, which are good result.

In addition, Fig. 4 shows dependence of chlorine density in the TiN film on wafer temperatures. As seen clearly from Fig. 4, when the process temperature is lower, chlorine density is higher, which is not preferable. (When the process temperature is enhanced, chlorine density is decreased.) However, in a case according to the present invention whose process temperature is 500 °C to 700 °C, chlorine density was not more than about 1 %. That is, with respect to the chlorine density, it has been found that the present invention can achieve a very good result. Herein, the number of cycles was sixteen, and a thin film having a thickness of 30 nm was formed.

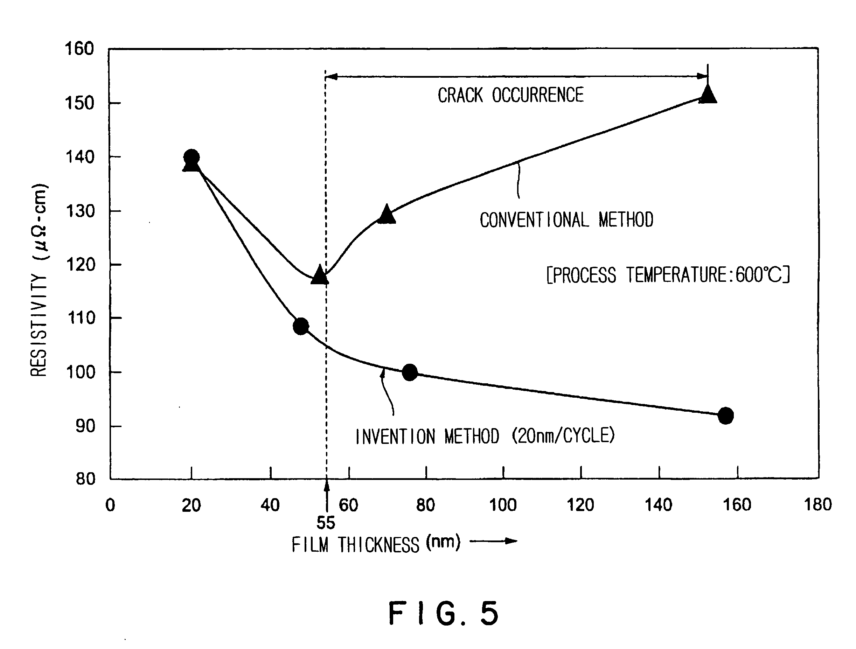

In addition, a relationship between film thicknesses and resistivities (relating to existence of cracks) is explained for a case wherein a film of a desired thickness is deposited by one gas-supply (conventional case), and for another case wherein a film of a desired thickness is deposited by a plurality of cycles of gas-supply and gas-supply stop in accordance with the present invention. Fig. 5 is a graph showing the relationship between film thicknesses and resistivities. Herein, in the case according to the present invention, during one cycle of gas-supply, a thin film having a thickness of about 20 nm was formed. The process temperature was 600 °C for both cases.

As seen clearly from Fig. 5, in the conventional case, as the film thickness (TiN film) is increased, the resistivity is decreased temporarily, and increased from a bottom at a film thickness of about 55 nm. In an area more than 55 nm of the film thickness, cracks may be generated in the deposited film, so that the resistivity may be increased.

On the other hand, in the case according to the present invention, as the film thickness is increased, the resistivity is decreased in turn. At least, the resistivity continues to be decreased to a point wherein the whole film thickness reaches about 160 nm. That is, it was confirmed that no crack may be generated.

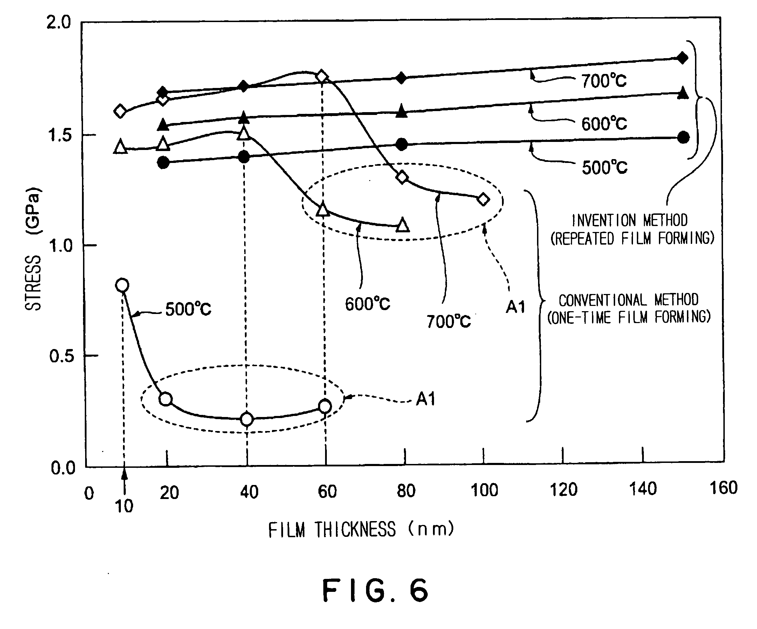

Next, temperature dependency of stress on a film thickness was evaluated. The evaluation result is explained. When a crack is generated in a deposited film, a stress of the deposited film is rapidly released (decreased). Thus, it can be confirmed whether a crack is generated or not, by measuring the stress. Fig. 6 is a graph showing temperature dependency of stresses with respect to film thicknesses. Herein, for respective process temperatures of 500 to 700 °C, shown are a case wherein a TiN film is deposited by one gas-supply (conventional method), and another case wherein a TiN film is deposited by intermittently and repeatedly supplying a TiCl₄ gas and an NH₃ gas in accordance with the present invention. As described above, it may be thought that cracks may be generated at portions (areas A1) wherein the stress is rapidly decreased.

As seen clearly from Fig. 6, in the conventional case, as the process temperature is increased in order of 500 °C, 600 °C and 700 °C, the film thickness of the TiN film that causes crack generation is also increased in order of about 20 nm, about 60 nm, and about 80 nm. Herein, if the process temperature is set higher than 700 °C, when a semiconductor integration circuit is manufactured, various types of base thin films or the like, which has already been formed in the previous step of the TiN-film forming step, may be thermally badly affected, which is not suitable. That is, the maximum value of a film thickness formed by one gas-supply (one cycle) is about 60 nm when the process temperature is 700 °C.

On the other hand, in the case according to the present invention, within the range of 500 °C to 700 °C, the stress is maintained high, and no crack is generated. That is, it was confirmed that the present invention can achieve a good result. Herein, in the case of the present invention, the film thickness deposited by one supply of the TiCl₄ gas was not more than about 10 nm when the process temperature was 500 °C, not more than about 40 nm when the process temperature was 600 °C, and not more than about 60 nm when the process temperature was 700 °C.

As a result, for example, in order to form a TiN film having a thickness of 180 nm at a process temperature of 700 °C, it is sufficient to conduct three cycles of film-forming steps for a thickness of 60 nm repeatedly. In addition, the minimum value of a film thickness formed by one gas-supply (one cycle) is preferably not less than about 30 nm, taking into consideration throughput, although crack generation is more inhibited as the film thickness is thinner.

Next, a first variant of the first embodiment is explained.

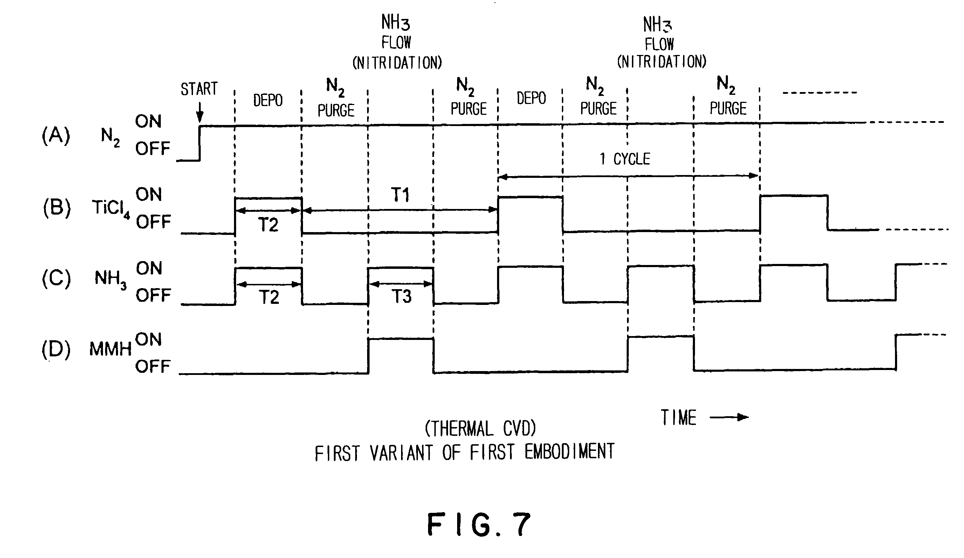

Fig. 7 is a chart showing timings of supply of various gases in the first variant of the first embodiment. The explanation of the same gases as in Fig. 2 is omitted.

The feature of the variant is that a TiN film is deposited by a thermal CVD by supplying a second nitrogen-including reduction gas, for example a monomethylhydrazine (MMH) gas (see Fig. 7(D)), in addition to the gas supplying manner of the first embodiment.

That is, during the non-supply terms T1 of the TiCl₄ gas as the metal source gas, at the same time that the NH₃ gas as the nitrogen-including reduction gas is supplied, the MMH gas as the second nitrogen-including reduction gas whose reducing power is greater than that of the nitrogen-including reduction gas is adapted to be supplied.

By using a gas whose reducing power is greater than that of the NH₃ gas, like the MMH gas, as the second nitrogen-including reduction gas, nitiriding power can be improved when the gas is supplied. Thus, the chlorine density can be more reduced, so that a more complete TiN film can be formed.

Next, a second variant of the first embodiment is explained.

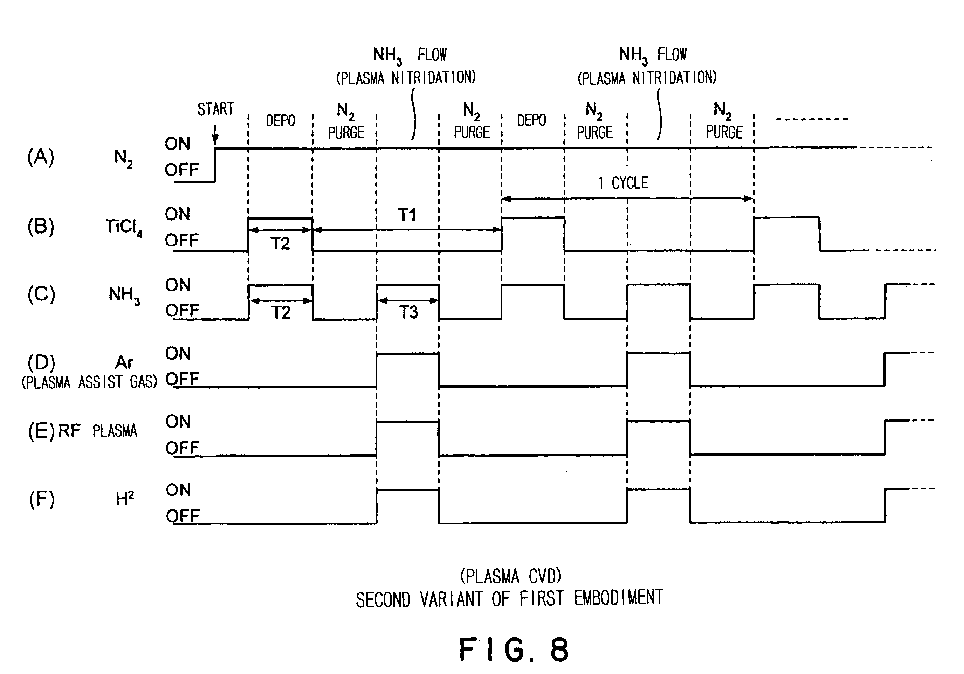

Fig. 8 is a chart showing timings of supply of various gases and timings of generation of plasma, in the second variant of the first embodiment. The explanation of the same gases as in Fig. 2 is omitted.

The feature of the variant is that a TiN film is deposited by a plasma CVD: by adding a plasma assist gas, for example an Ar gas (see Fig. 8(D)), so as to generate plasma; and at that time by adding a reduction gas, for example an H₂ gas (see Fig. 8(F)), if necessary; in addition to the gas supplying manner of the first embodiment.

That is, during the non-supply terms T1 of the TiCl₄ gas as the metal source gas, at the same time that the NH₃ gas as the nitrogen-including reduction gas is supplied, the Ar gas as the plasma assist gas is supplied so as to generate the plasma. In the case, the Ar gas is supplied only while the NH₃ FLOW is conducted, and a high-frequency electric voltage is applied to the upper electrode 16 so as to generate the plasma. Thus, nitriding power to the TiN film is further enhanced, and thus a more complete TiN film whose chlorine density is smaller can be formed. The high-frequency electric voltage can be applied to both the upper electrode 16 and the lower electrode 40.

In addition, when the plasma is generated, as shown in Fig. 8(F), the H₂ gas as the reduction gas can be supplied so as to improve the nitriding power further more.

Next, a second embodiment of the present invention is explained.

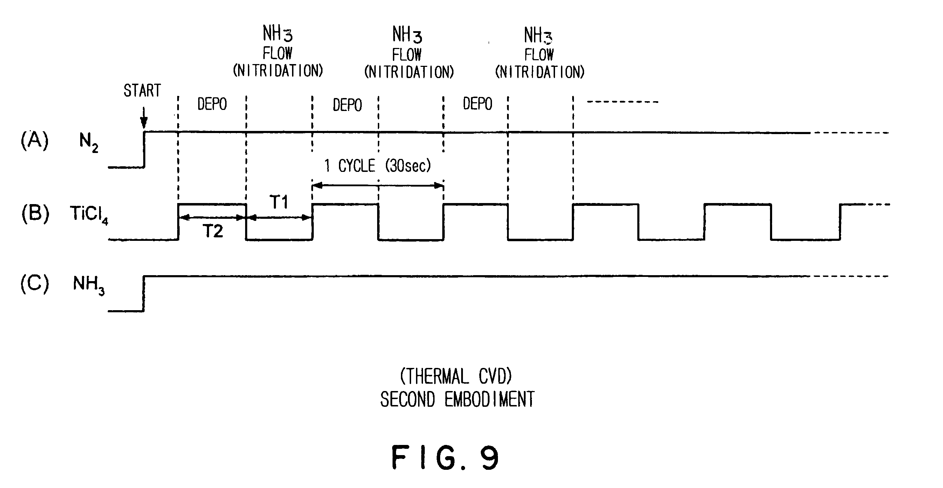

Fig. 9 is a chart showing timings of supply of various gases in the second embodiment according to the present invention.

Herein, an inert gas and a nitrogen-including reduction gas are continuously supplied, while a metal source gas is intermittently supplied. That is, an N₂ gas as the inert gas and an NH₃ gas as the nitrogen-including reduction gas are continuously supplied, while a TiCl₄ gas as the metal source gas is intermittently supplied in accordance with a pulse-pattern in time. Thus, a TiN film is deposited by a thermal CVD. Then, a step cycle of DEPO → NH₃ FLOW (nitridation) (→ DEPO → NH₃ FLOW (nitridation)) ... is repeated in sequence. In the case shown in Fig. 9, a supply term T2 and a non-supply term T1 of the TiCl₄ gas are set to substantially the same term. In addition, the term of the cycle is for example about 30 seconds.

In the second embodiment as well, it is possible to lower chlorine density that may be contained in the TiN film, even at a relatively high process temperature, by intermittently depositing a plurality of very thin films in sequence by intermittently supplying the film-forming gas. In addition, the TiN film can have a low resistivity, and fewer cracks may occur in the TiN film.

In addition, in the case of the second embodiment, the DEPO step for supplying the TiCl₄ gas and the nitriding step of the NH₃ FLOW are continuous (adjacent), that is, there is no N₂ PURGE step, differently from the first embodiment shown in Fig. 2. Thus, when the supply of the TiCl₄ gas is started and stopped, a state may be temporarily generated wherein density (partial pressure) of the TiCl₄ gas is extremely smaller than density (partial pressure) of the NH₃ gas, which is continuously supplied. This may act to deteriorate step coverage slightly. However, in the second embodiment, since the N₂ PURGE step is omitted, throughput may be enhanced.

Next, a first variant of the second embodiment is explained.

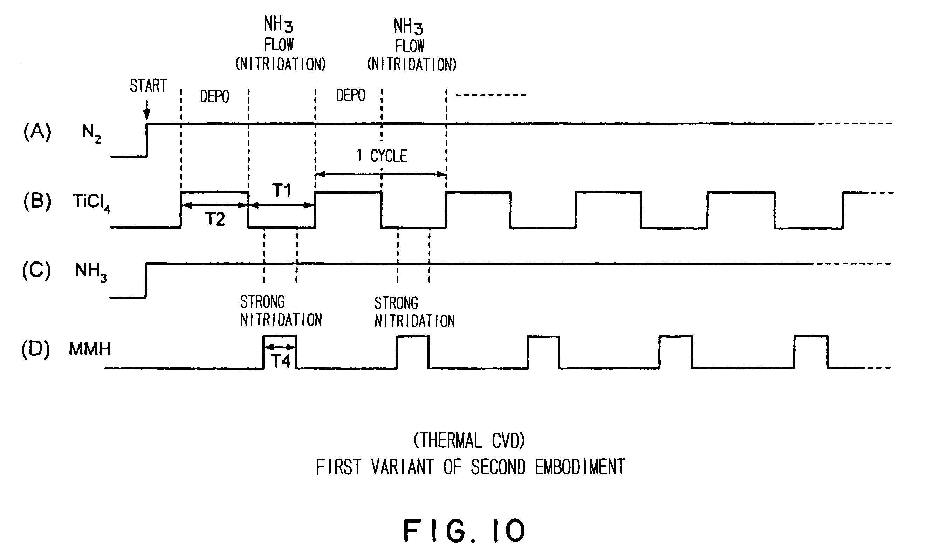

Fig. 10 is a chart showing timings of supply of various gases in the first variant of the second embodiment. The explanation of the same gases as in Fig. 9 is omitted.

The feature of the variant is that a TiN film is deposited by a thermal CVD by supplying a second nitrogen-including reduction gas, for example a monomethylhydrazine gas (see Fig. 10(D)), in addition to the gas supplying manner of the second embodiment.

That is, during the non-supply terms T1 of the TiCl₄ gas as the metal source gas, for terms T4 shorter than the non-supply terms T1, the MMH gas as the second nitrogen-including reduction gas, whose reducing power is greater than that of the NH₃ gas as the nitrogen-including reduction gas, is adapted to be supplied.

By using a gas whose reducing power is greater than that of the NH₃ gas, like the MMH gas, as the second nitrogen-including reduction gas, nitiriding power can be improved when the gas is supplied. Thus, the chlorine density can be more reduced, so that a more complete TiN film can be formed.

In addition, herein, the supply term T4 of the MMH gas is set at substantially the center of the non-supply term T1 of the TiCl₄ gas. In addition, the supply timing of the TiCl₄ gas and the supply timing of the MMH gas are different from each other so that both the gases are not supplied at the same time. Thus, nitriding power may not be too great, and step coverage may not be deteriorated.

Next, a second variant of the second embodiment is explained.

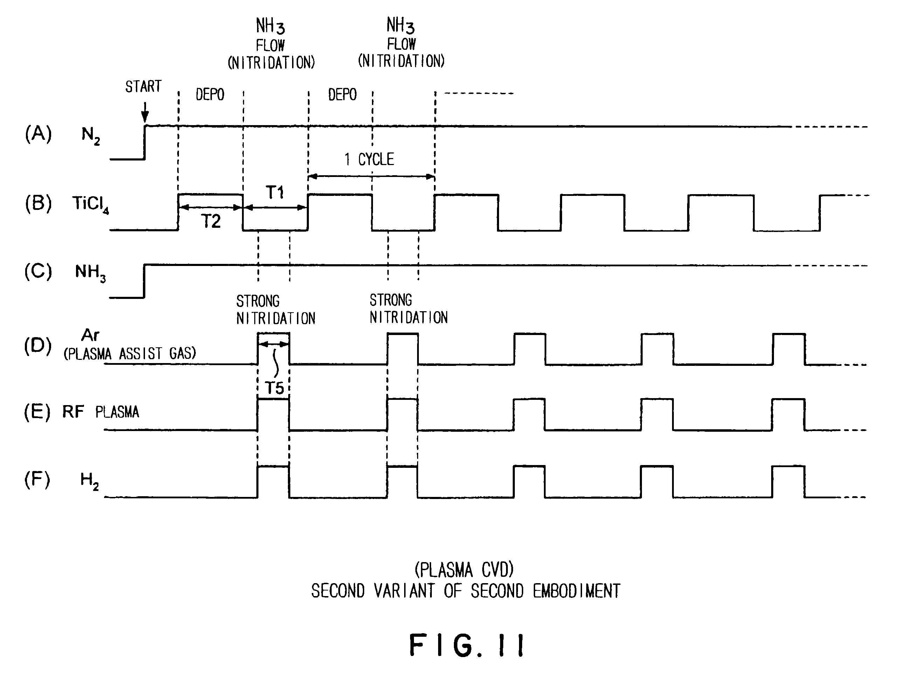

Fig. 11 is a chart showing timings of supply of various gases and timings of generation of plasma, in the second variant of the second embodiment. The explanation of the same gases as in Fig. 9 is omitted.

The feature of the variant is that a TiN film is deposited by a plasma CVD: by adding a plasma assist gas, for example an Ar gas (see Fig. 11(D)), so as to generate plasma; and at that time by adding a reduction gas, for example an H₂ gas (see Fig. 11(F)), if necessary; in addition to the gas supplying manner of the second embodiment.

That is, during the non-supply terms T1 of the TiCl₄ gas as the metal source gas, for terms T5 shorter than the non-supply terms T1, the Ar gas as the plasma assist gas is supplied so as to generate the plasma. Herein, the supply term T5 of the Ar gas is set at substantially the center of the non-supply term T1 of the TiCl₄ gas. Then, the Ar gas is supplied, and a high-frequency electric voltage is applied to the upper electrode 16, so as to generate the plasma. Thus, nitriding power to the TiN film is further enhanced, and thus a more complete TiN film whose chlorine density is smaller can be formed. In addition, when the plasma is generated, as shown in Fig. 11(F), the H₂ gas as the reduction gas can be supplied so as to improve the nitriding power further more.

In addition, in the case as well, the high-frequency electric voltage can be applied to both the upper electrode 16 and the lower electrode 40.

Next, a third embodiment of the present invention is explained.

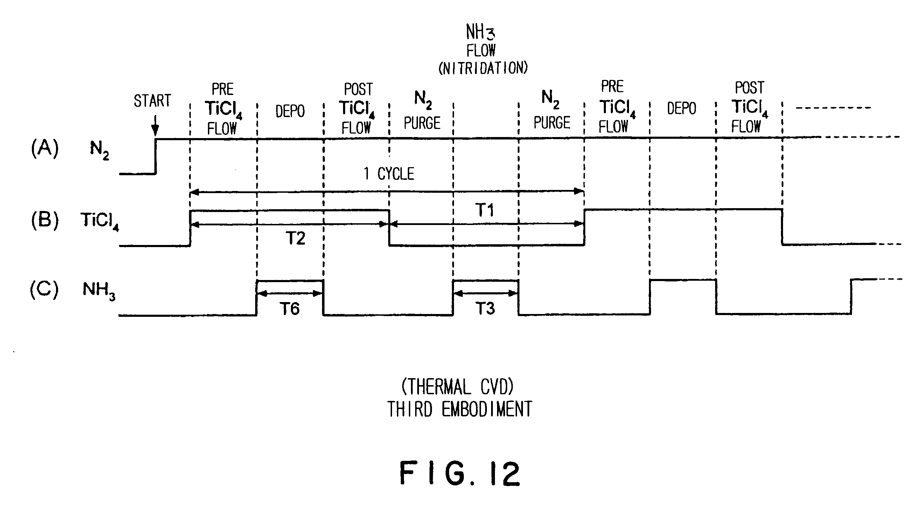

Fig. 12 is a chart showing timings of supply of various gases in the third embodiment according to the present invention.

Herein, an inert gas is continuously supplied, while a metal source gas is intermittently supplied. A nitrogen-including reduction gas is supplied during the supply terms T2 of the metal source gas, for terms T6 shorter than the supply terms T2, and also during the non-supply terms T1 of the metal source gas, for terms T3 shorter than the non-supply terms T1.

That is, an N₂ gas as the inert gas is continuously supplied, while a TiCl₄ gas as the metal source gas is intermittently supplied in accordance with a pulse-pattern in time. In addition, the NH₃ gas as the nitrogen-including reduction gas is supplied in accordance with a pulse-pattern in time, that is, for the terms T6 and T3 that are respectively shorter than the supply terms T2 and the non-supply terms T1 of the TiCl₄ gas, during the supply terms T2 and the non-supply terms T1 of the TiCl₄ gas. That is, there are a PRE-FLOW term and a POST-FLOW term of the TiCl₄ gas before and after the DEPO step. Thus, flow rate of the TiCl₄ gas is stabilized, and a TiN film is deposited by a thermal CVD. Then, a step cycle of PRE TiCl₄ FLOW → DEPO → POST TiCl₄ FLOW → N₂ PURGE → NH₃ FLOW (nitridation) → N₂ PURGE (→ PRE TiCl₄ FLOW → DEPO → POST TiCl₄ FLOW → N₂ PURGE) ... is repeated in sequence. In the case shown in Fig. 12, the supply term T6 of the NH₃ gas during the supply term T2 of the TiCl₄ gas is set at substantially the center of the supply term T2 of the TiCl₄ gas, and the supply term T3 of the NH₃ gas during the non-supply term T1 of the TiCl₄ gas is set at substantially the center of the non-supply term T1 of the TiCl₄ gas. In addition, the term of the cycle is for example about 15 to 70 seconds.

In the third embodiment as well, it is possible to lower chlorine density that may be contained in the TiN film, even at a relatively high process temperature, by intermittently depositing a plurality of very thin films in sequence by intermittently supplying the film-forming gas. In addition, the TiN film can have a low resistivity, and fewer cracks may occur in the TiN film.

In the case of the third embodiment, the PRE-FLOW step of the TiCl₄ gas and the POST-FLOW step of the TiCl₄ gas are provided before and after the DEPO step so that the flow rate of the TiCl₄ gas is stabilized. In addition, the N₂ PURGE steps are provided before and after the NH₃ FLOW (nitridation) step, so as to completely discharge redundant gases. Therefore, step coverage may be improved more.

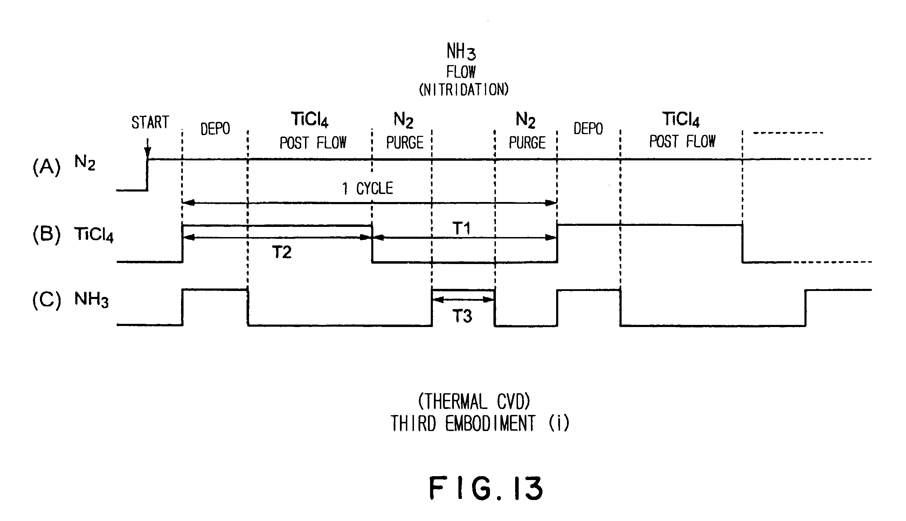

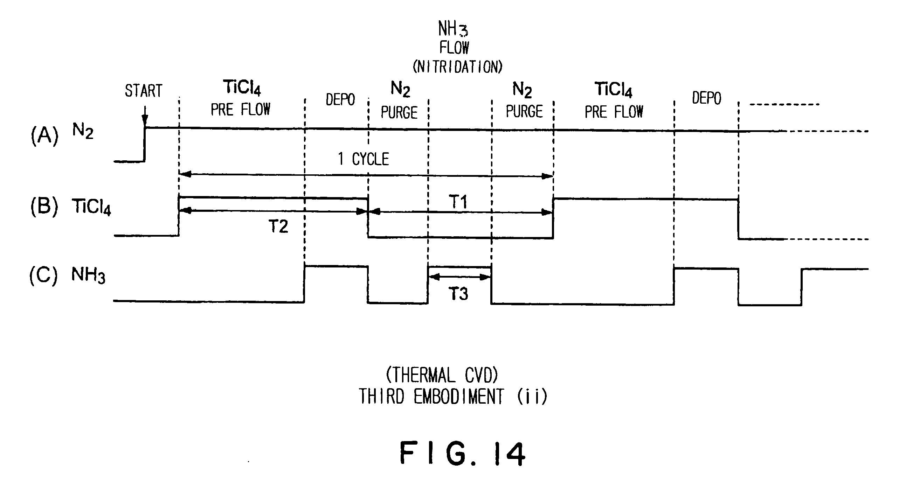

In the case, as shown in the third embodiment (i) of Fig. 13, during the supply term of the TiCl₄ gas (metal-source gas), the timing at which the NH₃ gas (nitrogen-including reduction gas) starts to be supplied and the timing at which the TiCl₄ gas starts to be supplied may be set at the same time. Alternatively, as shown in the third embodiment (ii) of Fig. 14, during the supply term of the TiCl₄ gas (metal-source gas), the timing at which the NH₃ gas (nitrogen-including reduction gas) ceases to be supplied and the timing at which the TiCl₄ gas ceases to be supplied may be set at the same time.

Next, a first variant of the third embodiment is explained.

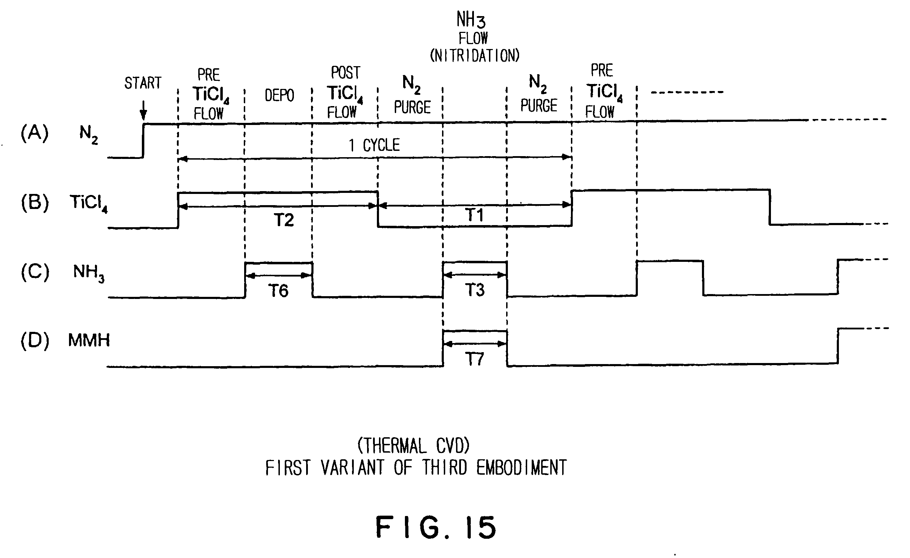

Fig. 15 is a chart showing timings of supply of various gases in the first variant of the third embodiment (including (i) and (ii)). The explanation of the same gases as in Fig. 12 is omitted. In addition, in Fig. 15, the timings of supply of various gases are shown on the basis of the timings shown in Fig. 12.

The feature of the variant is that a TiN film is deposited by a thermal CVD by supplying a second nitrogen-including reduction gas, for example a monomethylhydrazine gas (see Fig. 15(D)), in addition to the gas supplying manner of the third embodiment.

That is, during the non-supply terms T1 of the TiCl₄ gas as the metal source gas, at the same time that the NH₃ gas as the nitrogen-including reduction gas is supplied, the MMH gas as the second nitrogen-including reduction gas whose reducing power is greater than that of the nitrogen-including reduction gas is adapted to be supplied.

By using a gas whose reducing power is greater than that of the NH₃ gas, like the MMH gas, as the second nitrogen-including reduction gas, nitiriding power can be improved when the gas is supplied. Thus, the chlorine density can be more reduced, so that a more complete TiN film can be formed.

Next, a second variant of the third embodiment (including (i) and (ii)) is explained.

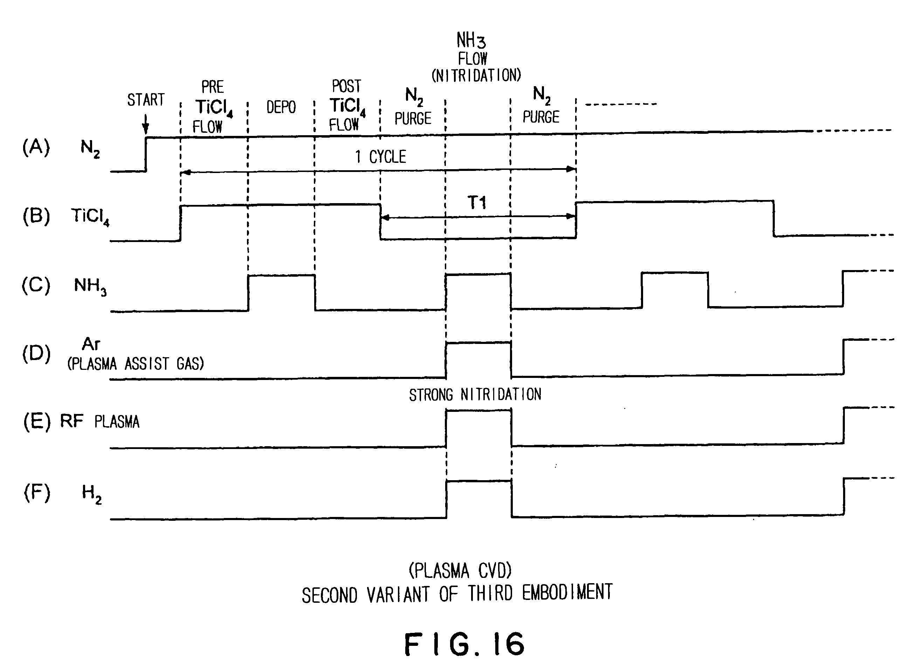

Fig. 16 is a chart showing timings of supply of various gases and timings of generation of plasma, in the second variant of the third embodiment. The explanation of the same gases as in Fig. 12 is omitted. In addition, in Fig. 16, the timings of supply of various gases are shown on the basis of the timings shown in Fig. 12.

The feature of the variant is that a TiN film is deposited by a plasma CVD: by adding a plasma assist gas, for example an Ar gas (see Fig. 16(D)), so as to generate plasma; and at that time by adding a reduction gas, for example an H₂ gas (see Fig. 16(F)), if necessary; in addition to the gas supplying manner of the third embodiment.

That is, during the non-supply terms T1 of the TiCl₄ gas as the metal source gas, at the same time that the nitrogen-including reduction gas is supplied, the Ar gas as the plasma assist gas is supplied so as to generate the plasma. In the case, the Ar gas is supplied only while the NH₃ FLOW is conducted, and a high-frequency electric voltage is applied to the upper electrode 16 so as to generate the plasma. Thus, nitriding power to the TiN film is further enhanced, and thus a more complete TiN film whose chlorine density is smaller can be formed. In addition, when the plasma is generated, as shown in Fig. 16(F), the H₂ gas as the reduction gas can be supplied so as to improve the nitriding power further more.

In addition, in the case as well, the high-frequency electric voltage can be applied to both the upper electrode 16 and the lower electrode 40.

Next, a fourth embodiment of the present invention is explained.

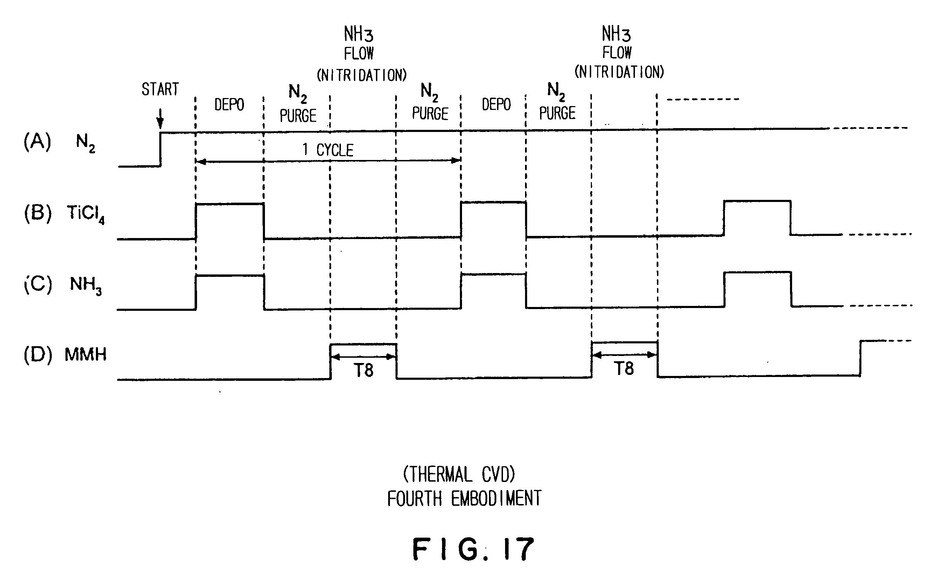

Fig. 17 is a chart showing timings of supply of various gases in the fourth embodiment according to the present invention.

Herein, an inert gas is continuously supplied, a metal source gas is intermittently supplied, and a nitrogen-including reduction gas is supplied at the same time that the metal source gas is supplied. In addition, a second nitrogen-including reduction gas is supplied during non-supply terms of the metal source gas, for terms shorter than the non-supply terms. Thus, a TiN film is deposited by a thermal CVD.

That is, an N₂ gas as the inert gas is continuously supplied, while a TiCl₄ gas as the metal source gas and an NH₃ gas as the nitrogen-including reduction gas are synchronously and intermittently supplied in accordance with a pulse-pattern in time. In addition, during the non-supply terms of the TiCl₄ gas, for terms shorter than the non-supply terms, a MMH gas as the second nitrogen-including reduction gas, whose reducing power is greater than that of the NH₃ gas, is supplied. Thus, the TiN film is deposited by the thermal CVD. That is, the TiN film is nitrided when the MMH gas is supplied (reduction of the chlorine is carried out).

The fourth embodiment is a gas supplying manner corresponding to that wherein the supply terms T3 of the NH₃ gas are removed from the first variant of the first embodiment shown in Fig. 7. Thus, the supply terms T3 in Fig. 7 correspond to the supply terms T8 of the MMH gas in Fig. 17. Thus, a step cycle of DEPO → N₂ PURGE → MMH FLOW (nitridation) → N₂ PURGE (→ DEPO → N₂ PURGE → MMH FLOW (nitridation)) ... is repeated in sequence.

In the fourth embodiment as well, it is possible to lower chlorine density that may be contained in the TiN film, even at a relatively high process temperature, by intermittently depositing a plurality of very thin films in sequence by intermittently supplying the film-forming gas. In addition, the TiN film can have a low resistivity, and fewer cracks may occur in the TiN film.

In addition, the term of the cycle is for example about 10 to 60 seconds.

Next, a fifth embodiment of the present invention is explained.

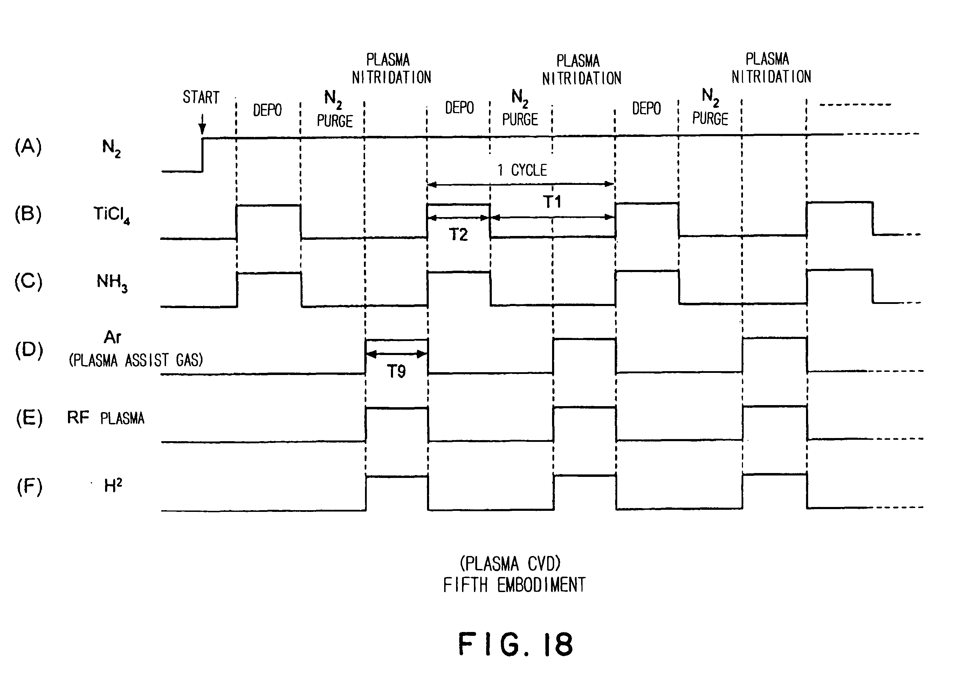

Fig. 18 is a chart showing timings of supply of various gases and timings of generation of plasma, in the fifth embodiment according to the present invention.

Herein, an inert gas is continuously supplied, a metal source gas is intermittently supplied, and a nitrogen-including reduction gas is supplied at the same time that the metal source gas is supplied. In addition, a plasma assist gas is supplied during non-supply terms of the metal source gas, for terms shorter than the non-supply terms and continuous to the next supply terms of the metal-source gas, so as to generate plasma.

That is, an N₂ gas as the inert gas is continuously supplied, while a TiCl₄ gas as the metal source gas and an NH₃ gas as the nitrogen-including reduction gas are synchronously and intermittently supplied in accordance with a pulse-pattern in time. In addition, during the non-supply terms T1 of the TiCl₄ gas, for shorter terms T9 continuous to the next supply terms T2 of the TiCl₄ gas, an Ar gas as the plasma assist gas (see Fig. 18(D)) is added to generate the plasma (see Fig. 18(E)).

In addition, if necessary, a reduction gas, for example an H₂ gas (see Fig. 18(F)), is added at that time, so that a TiN film is deposited by a plasma CVD. Thus, a step cycle of DEPO → N₂ PURGE → plasma nitridation (→ DEPO → N₂ PURGE → plasma nitridation) ... is repeated in sequence.

In the case of the present embodiment, when the Ar gas is supplied, a high-frequency electric voltage is applied to the upper electrode 16 so as to generate the plasma. Thus, nitriding power to the TiN film is further enhanced, and thus a more complete TiN film whose chlorine density is smaller can be formed. In addition, when the plasma is generated, as shown in Fig. 18(F), the H₂ gas as the reduction gas can be supplied so as to improve the nitriding power further more.

In addition, in the case as well, the high-frequency electric voltage can be applied to both the upper electrode 16 and the lower electrode 40.

In the fifth embodiment as well, it is possible to lower chlorine density that may be contained in the TiN film, even at a relatively high process temperature, by intermittently depositing a plurality of very thin films in sequence by intermittently supplying the film-forming gas. In addition, the TiN film can have a low resistivity, and fewer cracks may occur in the TiN film.

In addition, in the present embodiment, the NH₃ gas is not supplied during the plasma nitriding step (term T9). Thus, the plasma nitridation is conducted by the N₂ purge gas, so that the DEPO step (term T2) can be immediately conducted without necessity to conduct any N₂ PURGE step for discharging the NH₃ gas just after the plasma nitriding step. Thereby, throughput may be improved. In addition, the term of the cycle of the present embodiment is about 5 to 60 seconds.

In the above embodiments, the MMH gas is used as the second nitrogen-including reduction gas whose reducing power is great. However, this invention is not limited thereto, but other gases such as hydrazine or dimethylhydrazine may be also used.

### <Cases wherein a TiN film is formed on a base layer consisting of Ti>

In the embodiments and the variants thereof, a kind of base layer onto which the TiN film is formed is not explained. However, if the base layer is a Ti film, the TiN film formed thereon tends to peel off very easily. Thus, a film thickness of the TiN film to be formed by one cycle (including one supply term of the metal-source gas) is much thinner than the above case, that is, 40 to 60 nm / cycle. Specifically, for example, it has to be reduced to a range of less than 20 nm / cycle.

The reason is explained hereinafter. The TiCl₄ gas supplied during a deposition process of the TiN film lightly etches the Ti film, so that TiClₓ is formed as a reaction byproduct. The reaction byproduct may not be evaporated sufficiently, but may partly remain on a surface of the Ti film. The remaining reaction byproduct facilitates the peeling off of the TiN film.

In order to inhibit the easiness of the peeling off, in conventional film-forming methods, after a Ti layer is formed by a CVD or a PVD (Physical Vapor Deposition), a thin TiN film is formed at a surface of the Ti layer by a nitriding process using N₂ or NH₃. Then, on the thin TiN film, another thick TiN film is formed. Thus, in such conventional methods, the number of steps is large because the above nitriding process is necessary on the way.

On the other hand, according to the present invention, if the supply and the stop of each gas are repeatedly conducted, the remaining reaction byproduct is completely nitrided. Thus, the peeling off of the TiN film is inhibited. Then, the nitriding process that is necessary in the conventional methods becomes unnecessary, so that the number of steps may be reduced. Specifically, when the base layer is the Ti layer, in order to completely nitride the reaction byproduct, as described above, it is necessary to reduce a thickness of the TiN film formed by one cycle to not more than 20 nm. In addition, a maximum film thickness by one cycle that can prevent peeling off also depends on a thickness of the total TiN film to be finally formed.

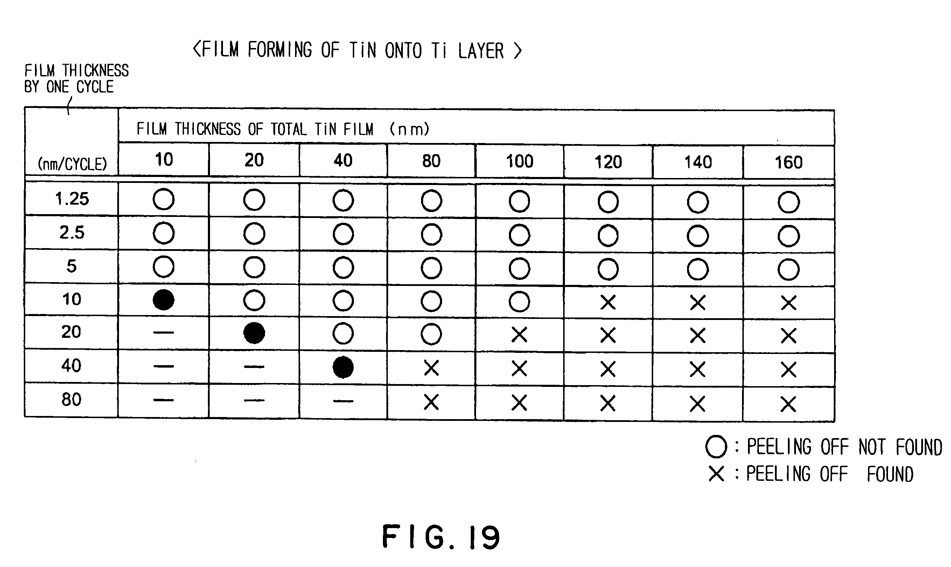

Herein, a maximum film thickness by one cycle when a TiN film is deposited on a base layer consisting of a Ti layer in accordance with the present invention was evaluated in relation to a film thickness of the total TiN film to be formed. The evaluation result is explained. Fig. 19 is a table showing a relationship between film thicknesses of the total TiN film and film thicknesses formed by one cycle. Herein, the film thickness of the total TiN film was changed between 10 nm and 160 nm. On the other hand, the film thickness by one cycle was changed between 1.25 nm and 80 nm. At that time, the process temperature was about 650 °C. In the table, the sign "○" shows a case in which peeling off is not found, and hence which is good. The sign "×" shows a case in which peeling off is found, and hence which is not good. The sign "●" shows a case in which peeling off is not found, but the thin film consists of one layer. Herein, no crack was found in all the deposited films.

As shown in Fig. 19, if the film thickness of one cycle is not more than 5 nm, even when the film thickness of the total TiN film is about 160 nm, peeling off was not found, that is, the result was good. In addition, peeling off was not found even when the film thickness of the total TiN film is greater than 160 nm, but the explanation is omitted.

Then, if the film thickness of the total TiN film is thinner than about 100 nm, the film thickness to be formed by one cycle is as thick as 10 to 20 nm. For example, when the total film thickness is about 100 nm, the maximum film thickness to be formed by one cycle is about 10 nm, and when the total film thickness is about 80 nm, the maximum film thickness to be formed by one cycle is about 20 nm. As the film thickness of the total TiN film is reduced, the stress of the TiN film is also gradually reduced, so that the maximum film thickness to be formed by one cycle is gradually increased.

As described above, from Fig. 19, it was confirmed that peeling off doesn't occur if the film thickness of the total TiN film is 40 to 80 nm even when the film thickness of one cycle is about 20 nm.

In addition, in the above embodiments and the variants thereof, the TiN film is formed as a metal-nitride film. However, this invention is not limited thereto, but applicable to cases for forming other metal-nitride films such as a WN film or a TaN film.

In addition, in the above embodiments, the semiconductor wafer is taken as an example of the object to be processed. However, this invention is not limited thereto, but applicable to cases for processing a glass substrate, an LCD substrate, and the like.

## Claims

1. A film-forming method of forming a metal-nitride film onto a surface of an object to be processed in a processing container in which a vacuum can be created, the film-forming method comprising:
a step of continuously supplying an inert gas into a processing container set at a high film-forming temperature,
a step of intermittently supplying a metal-source gas into the processing container, during the step of continuously supplying the inert gas,
a step of supplying a nitrogen-including reduction gas into the processing container at the same time that the metal-source gas is supplied, during a supply term of the metal-source gas, during the step of intermittently supplying the metal-source gas, and
a step of supplying the nitrogen-including reduction gas into the processing container for a term shorter than a non-supply term of the metal-source gas, during the non-supply term of the metal-source gas, during the step of intermittently supplying the metal-source gas,
wherein a film thickness of the metal-nitride film formed during the one supply term of the metal-source gas is not more than 60 nm.

2. A film-forming method according to claim 1, wherein
the high film-forming temperature is 500 °C to 700 °C.

3. A film-forming method according to claim 1, wherein
during the step of supplying the nitrogen-including reduction gas into the processing container for a term shorter than a non-supply term of the metal-source gas, during the non-supply term of the metal-source gas, a second nitrogen-including reduction gas, whose reducing power is greater than that of the nitrogen-including reduction gas, is supplied at the same time that the nitrogen-including reduction gas is supplied.

4. A film-forming method according to claim 1, wherein
during the step of supplying the nitrogen-including reduction gas into the processing container for a term shorter than a non-supply term of the metal-source gas, during the non-supply term of the metal-source gas, a plasma-assist gas is supplied at the same time that the nitrogen-including reduction gas is supplied, so as to generate plasma.

5. A film-forming method according to claim 4, wherein
a reduction gas is supplied at the same time that the plasma-assist gas is supplied.

6. A film-forming method of forming a metal-nitride film onto a surface of an object to be processed in a processing container in which a vacuum can be created, the film-forming method comprising:
a step of continuously supplying an inert gas and a nitrogen-including reduction gas into a processing container set at a high film-forming temperature, and
a step of intermittently supplying a metal-source gas into the processing container, during the step of continuously supplying the inert gas and the nitrogen-including reduction gas,
wherein a film thickness of the metal-nitride film formed during the one supply term of the metal-source gas is not more than 60 nm.

7. A film-forming method according to claim 6, wherein
the high film-forming temperature is 500 °C to 700 °C.

8. A film-forming method according to claim 6, wherein
a second nitrogen-including reduction gas, whose reducing power is greater than that of the nitrogen-including reduction gas, is supplied into the processing container for a term shorter than a non-supply term of the metal-source gas, during the non-supply term of the metal-source gas, during the step of intermittently supplying the metal-source gas.

9. A film-forming method according to claim 6, wherein
a plasma-assist gas is supplied into the processing container for a term shorter than a non-supply term of the metal-source gas, during the non-supply term of the metal-source gas, during the step of intermittently supplying the metal-source gas, so as to generate plasma.

10. A film-forming method according to claim 9, wherein
a reduction gas is supplied at the same time that the plasma-assist gas is supplied.

11. A film-forming method of forming a metal-nitride film onto a surface of an object to be processed in a processing container in which a vacuum can be created, the film-forming method comprising:
a step of continuously supplying an inert gas into a processing container set at a high film-forming temperature,
a step of intermittently supplying a metal-source gas into the processing container, during the step of continuously supplying the inert gas,
a step of supplying a nitrogen-including reduction gas into the processing container for a term shorter than a supply term of the metal-source gas, during the supply term of the metal-source gas, during the step of intermittently supplying the metal-source gas, and
a step of supplying the nitrogen-including reduction gas into the processing container for a term shorter than a non-supply term of the metal-source gas, during the non-supply term of the metal-source gas, during the step of intermittently supplying the metal-source gas,
wherein a film thickness of the metal-nitride film formed during the one supply term of the metal-source gas is not more than 60 nm.

12. A film-forming method according to claim 11, wherein
the high film-forming temperature is 500 °C to 700 °C.

13. A film-forming method according to claim 11, wherein
during the step of supplying the nitrogen-including reduction gas into the processing container for a term shorter than a supply term of the metal-source gas, during the supply term of the metal-source gas, either the start or the stop of supplying the nitrogen-including reduction gas is set at the same time as either the start or the stop of supplying the metal-source gas.

14. A film-forming method according to claim 11, wherein
during the step of supplying the nitrogen-including reduction gas into the processing container for a term shorter than a non-supply term of the metal-source gas, during the non-supply term of the metal-source gas, a second nitrogen-including reduction gas, whose reducing power is greater than that of the nitrogen-including reduction gas, is supplied at the same time that the nitrogen-including reduction gas is supplied.

15. A film-forming method according to claim 11, wherein
during the step of supplying a nitrogen-including reduction gas into the processing container for a term shorter than a non-supply term of the metal-source gas, during the non-supply term of the metal-source gas, a plasma-assist gas is supplied at the same time that the nitrogen-including reduction gas is supplied, so as to generate plasma.

16. A film-forming method according to claim 15, wherein
a reduction gas is supplied at the same time that the plasma-assist gas is supplied.

17. A film-forming method of forming a metal-nitride film onto a surface of an object to be processed in a processing container in which a vacuum can be created, the film-forming method comprising:
a step of continuously supplying an inert gas into a processing container set at a high film-forming temperature,
a step of intermittently supplying a metal-source gas into the processing container, during the step of continuously supplying the inert gas,
a step of supplying a nitrogen-including reduction gas into the processing container at the same time that the metal-source gas is supplied, during a supply term of the metal-source gas, during the step of intermittently supplying the metal-source gas, and
a step of supplying a second nitrogen-including reduction gas, whose reducing power is greater than that of the nitrogen-including reduction gas, into the processing container for a term shorter than a non-supply term of the metal-source gas, during the non-supply term of the metal-source gas, during the step of intermittently supplying the metal-source gas,
wherein a film thickness of the metal-nitride film formed during the one supply term of the metal-source gas is not more than 60 nm.

18. A film-forming method according to claim 17, wherein
the high film-forming temperature is 500 °C to 700 °C.

19. A film-forming method of forming a metal-nitride film onto a surface of an object to be processed in a processing container in which a vacuum can be created, the film-forming method comprising:
a step of continuously supplying an inert gas into a processing container set at a high film-forming temperature,
a step of intermittently supplying a metal-source gas into the processing container, during the step of continuously supplying the inert gas,
a step of supplying a nitrogen-including reduction gas into the processing container at the same time that the metal-source gas is supplied, during a supply term of the metal-source gas, during the step of intermittently supplying the metal-source gas, and
a step of supplying a plasma-assist gas into the processing container for a term shorter than a non-supply term of the metal-source gas and continuous to the next supply term of the metal-source gas, during the non-supply term of the metal-source gas, during the step of intermittently supplying the metal-source gas, so as to generate plasma,
wherein a film thickness of the metal-nitride film formed during the one supply term of the metal-source gas is not more than 60 nm.

20. A film-forming method according to claim 19, wherein
the high film-forming temperature is 500 °C to 700 °C.

21. A film-forming method according to claim 19, wherein
a reduction gas is supplied at the same time that the plasma-assist gas is supplied.

22. A film-forming method according to claim 1, wherein
the metal-source gas is TiCl₄ gas, and
the nitrogen-including reduction gas is NH₃ gas.

23. A film-forming method according to claim 22, wherein
a Ti layer has been formed as a base layer on the surface of the object to be processed, onto which the metal-nitride film is to be formed, and
a film thickness of the metal-nitride film formed during the one supply term of the metal-source gas is not more than 20 nm.

24. A film-forming method according to claim 1, wherein
the inert gas is N₂ gas.

25. A film-forming method according to claim 1, wherein
the inert gas is Ar gas.

26. A film-forming method according to claim 3, wherein
the second nitrogen-including reduction gas is any of hydrazine, monomethylhydrazine and dimethylhydrazine.
